# EUROPEAN PATENT SPECIFICATION

(11) **EP 0 860 764 B1**
(45) Date of publication and mention of the grant of the patent: **15.10.2003**
(21) Application number: 98400303.8
(22) Date of filing: 11.02.1998
(51) Int. Cl.: G06F 3/00, H03J 1/00

(54) **System for controlling information available on video and/or audio equipment by graphical display**
System zur Steuerung von Information, die zur Anzeige an einem Videogerät und/oder Audiogerät verfügbar ist
Système de contrôle d'informations disponibles par affichage graphique sur des équipements vidéo et/ou audio

(30) Priority: 20.02.1997 FR 9702004
(43) Date of publication of application: 26.08.1998
(73) Proprietor: THOMSON multimedia, 92648 Boulogne Cédex (FR)
(72) Inventor: Guerin, Benoit, 92648 Boulogne Cedex (FR)
(74) Representative: Ruellan-Lemonnier, Brigitte

(56) References cited:
- EP-A- 0 596 594
- WO-A-92/05641
- PATENT ABSTRACTS OF JAPAN vol. 011, no. 088 (E-490), 18 March 1987 & JP 61 240798 A (PIONEER ELECTRONIC CORP), 27 October 1986,
- PATENT ABSTRACTS OF JAPAN vol. 096, no. 012, 26 December 1996 & JP 08 221194 A (NIPPON TELEGR &TELEPH CORP <NTT>), 30 August 1996,

## Description

The invention relates to a system allowing the control, by graphical display on a screen, of information relating to various items of video and/or audio equipment.

More particularly, the invention relates to a system for controlling information such as that mentioned above by graphical display on a television screen.

The video and/or audio equipment may, for example, be video recorders, digital video disc readers, audio compact disc players or television programmes receivers.

Information which may be displayed on-screen can be information relating to the data processed by the video and/or audio equipment and/or information relating to the video and/or audio equipment itself.

By way of non-limiting examples, the information relating to the data processed by the video and/or audio equipment may be the title of a programme recorded on a video medium, in the case of a magnetic tape player or of a digital video disc player, or else a guide to the programmes available on a set of television channels which can be accessed by a television receiver.

The information relating to the video and/or audio equipment itself relates to the operation of the equipment. By way of non-limiting example, in the case in which the video equipment is a video recorder, the information then relates to recording, playing, fast-forwarding, rewinding or stopping the video recorder.

According to the prior art, a system of the type mentioned above comprises a display screen, a graphics interface device, a remote control device for the graphics interface device and a set of video and/or audio equipment.

In the remainder of the description, any video and/or audio equipment will be referred to by the generic term video and/or audio peripheral.

In order to allow the on-screen display of information relating to the programmes available on the peripherals as well as of the programmes themselves, the graphics interface device, the various peripherals and the screen are linked together by video connections.

The graphics interface device can, for example, be a PC type terminal (the letters PC standing for "Personal Computer"), a decoder allowing reception and transmission of digital information across the Internet network, or else a decoder allowing reception of telebroadcast video data.

Generally, the graphics interface device relates to any type of device that makes it possible to present an item of information which may be displayed on-screen.

According to the prior art, under the action of the device which remotely controls it, the graphics interface device makes it possible, on the one hand, to define and position a cursor on the screen and, on the other hand, to define screen areas corresponding to actions to be accomplished by the graphics interface device and/or by the audio and/or video peripherals. Each screen area is then assigned to the display of one or more abovementioned items of information.

In order to trigger the display of that information which is of interest to a user, the display system comprises means that make it possible to activate the peripheral containing this information and to switch the video information output by the relevant peripheral to the screen.

The peripheral is generally activated either with the aid of the peripheral's own remote control or with the aid of the device for controlling the graphics interface device itself.

In the latter case, a system of connections makes it possible to link each peripheral to the graphics interface device. The connections that enable the various peripherals to be linked to the graphics interface device are connections of computer type, electrical type or optical type.

These connections convey signals for controlling the display screen and the audio and/or video peripherals.

In the case of connections of optical type, an infrared source controlled by the graphics interface device (optical fibre or light-emitting diode) is placed in front of the infrared receiver which each peripheral contains and which the latter uses to receive the commands from the remote control associated therewith. This infrared receiver makes it possible to convert the infrared signal which it receives into an electrical signal so that the command output by the graphics interface device is applied to the peripheral.

EP-A-0596594 discloses a system comprising a controlling device whose functions comprise a remote control function, with a connection "through the air" to the target devices (peripherals); the connection 31 between the controlling device (i.e. remote control) to the host computer is bidirectional but nothing indicates that it is "through the air".

Irrespective of their embodiment, the display systems of the prior art are expensive and bulky systems requiring either the use of several remote controls or complicated wiring between the various peripherals.

The invention does not have these drawbacks.

That is because, the invention relates to a graphics interface device allowing the presentation and display on a screen of at least one item of information relating to at least one video and/or audio peripheral, the said device being remotely controllable by a remote control device. The graphics interface device comprises means that make it possible to send, through the air, a signal to the remote control device, which signal is modulated by a signal whose format makes it possible to specify a signal which the remote control device sends to the peripheral in order to trigger a command action relating to the item of information represented on the screen.

The invention also relates to a remote control device for a graphics interface device allowing the presentation and display on a screen of at least one item of information relating to at least one peripheral. The remote control device comprises means making it possible to receive a signal output by the graphics interface device and to send, to the peripheral, a modulated signal making it possible to trigger a command action relating to the item of information represented on the screen.

The invention further relates to an assembly consisting, on the one hand, of a graphics interface device allowing the display on a screen of at least one item of information relating to at least one video and/or audio peripheral and, on the other hand, of a remote control device for the graphics interface device, characterized in that the graphics interface device is a device such as that mentioned above according to the invention and in that the remote control device is a device such as that mentioned above according to the invention.

The invention also relates to a system allowing the control, by graphical display on a screen, of at least one item of information relating to at least one video and/or audio peripheral, the said system comprising a device comprising the said screen, a graphics interface device, a remote control device for the graphics interface device and at least one video and/or audio peripheral, characterized in that the graphics interface device is a device such as that mentioned above according to the invention and in that the remote control device is a device such as that mentioned above according to the invention.

Advantageously, the remote control device for the graphics interface device according to the invention comprises means enabling it to direct the commands which it receives from the graphics interface device towards the appropriate peripheral.

Other characteristics and advantages of the invention will emerge on reading about a preferred embodiment given with reference to the appended figures in which:
- Figure 1 represents a system allowing the on-screen display of information relating to various video and/or audio peripherals according to the preferred embodiment of the invention;
- Figure 2 represents, according to the invention, a detailed view of a graphics interface device interacting with the remote control device associated therewith;
- Figure 3 represents an improvement to the system represented in Figure 1.

In all the figures, the same labels denote the same elements.

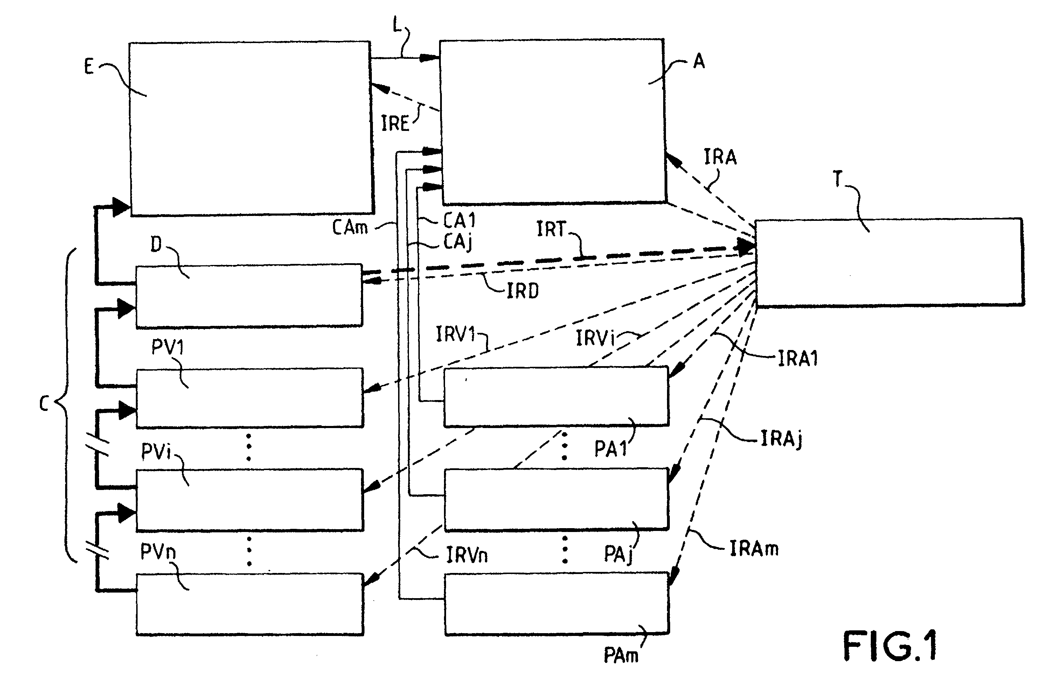

Figure 1 represents a system allowing the on-screen display of information relating to various video and/or audio peripherals 'according to the preferred embodiment of the invention.

The system represented in Figure 1 comprises a display screen E, a set of n video peripherals PV1, ..., PVi, ..., PVn, n being an integer greater than or equal to 1, m audio peripherals PA1, ..., PAj, ..., PAm, m being an integer greater than or equal to 1, an audio amplifier A, a graphics interface device D and a device T for the remote control of the device D.

The term device for the remote control of the device D should be understood to mean a device which sends signals, preferably in the infrared frequency range, for controlling the actions which the device D is to carry out.

The system represented in Figure 1 comprises video peripherals and audio peripherals. However, the invention also relates to a system comprising only one or more video peripherals or, alternatively, a system comprising only one or more audio peripherals.

The various video peripherals and the screen E are linked to the graphics interface device D by a system of video connections C.

Similarly, each audio peripheral PAj (j = 1, ..., m) is linked to the amplifier A by an electrical link CAj.

In Figure 1, the various elements of the system of connections C link the various video peripherals in a chain. Other configurations are, however, possible for linking each peripheral to the device D. A star configuration could, for example, be used.

According to the embodiment of the invention represented in Figure 1, a link L is established between the screen E and the amplifier A. This link allows amplification of the sound data associated with the video programme which appears on the screen E. According to other embodiments of the invention, there is no link between the amplifier A and the screen E.

As mentioned previously, according to the invention, the remote control device T not only sends signals allowing control of the device D but also receives signals originating from the device D. Thus, a signal IRT, whose frequency preferably lies in the infrared range, may be sent from the graphics interface device D to the device T.

According to the preferred embodiment of the invention, the remote control device T comprises means for processing the information which it receives from the device D and means that enable a signal containing the item of information for triggering the desired action on a peripheral to be redirected to the appropriate peripheral.

The information which enables the device T to trigger the desired action on any one of the peripherals PVi (i = 1 , . . . , n) or PAj (j = 1,..., m), or else on any one of the devices D, A or E, is then contained in the signal IRT and, as appropriate, in any one of the signals IRVi, IRAj, IRD, IRA or IRE which are resent, by the device T, under the action of the signal IRT.

According to the invention, the signal IRT is modulated by a signal whose format makes it possible to specify the signals which the device T must resend to the appropriate destination peripheral. The graphics interface device D then contains means that enable the signal IRT to be modulated. According to the preferred embodiment of the invention, the signal IRT is modulated by a digital signal.

The signal resent by the device T to the various peripherals is a signal modulated by a signal identical to or different from the signal which modulates the signal IRT.

Advantageously, in the case where the signal which modulates the signal resent by the device T is different from the signal which modulates the signal IRT, the display system D according to the invention can accommodate peripherals, the format of whose remote control signals is not compatible with the modulation of the signal IRT and with the format of the signals allowing remote control of the device D.

According to a simplified embodiment of the invention, the routing function of the control device T is performed simply by resending the infrared signal IRT. The function involving processing of the information received by the device T so as to generate the signals for controlling the appropriate peripheral is then dispensed with.

According to the preferred embodiment of the invention, the device T for remote control of the device D is also the device for remote control of each of the video peripherals PV1, ..., PVi, ..., PVn, of each of the audio peripherals PA1, ..., PAj, ..., PAm, of the device which comprises the screen E and of the amplifier A.

Thus, the items of apparatus PV1, ..., PVi, ..., PVn, PA1, ...PAj, ..., PAm, D, A, E can be controlled by the device T with the aid of the signals IRV1, ..., IRVi, ..., IRVn, IRA1, ..., IRAj, ..., IRAm, IRD, IRA and IRE, respectively.

Advantageously, all the peripherals need no longer be linked to the graphics interface device by the system of connections of computer, electrical or optical type described previously.

In response to a request made to the graphics interface device D by the user operating the device T, it must be possible to establish, by way of the device T, a control communication originating from the device D and directed to a peripheral to be controlled.

If the peripheral to be controlled is not visible to the device T during this control communication phase, it is not possible for the device D to communicate the control information to this peripheral.

According to an improvement to the invention, provision is then made to store the command dispatched by the device D in a memory circuit of the device T. The user can then once again command that the desired action, which has been stored as mentioned above, be carried out, at the desired moment, simply by pointing the device T at the peripheral to be activated.

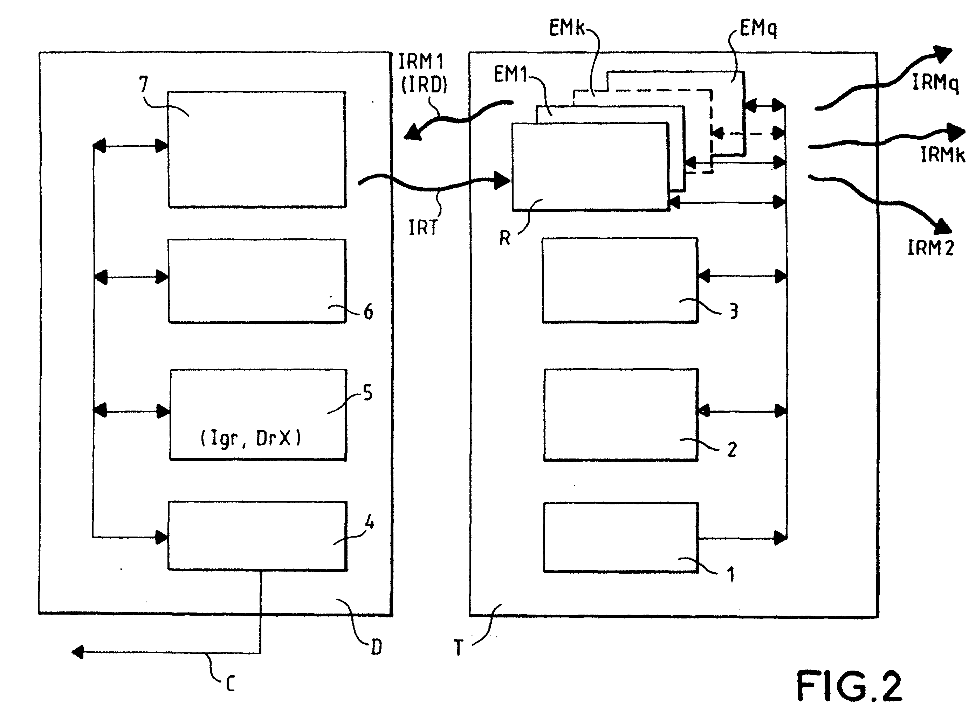

Figure 2 represents, according to the invention, a detailed view of a graphics interface device interacting with the remote control device associated therewith.

The graphics interface device D comprises a sender/receiver circuit 7, a microprocessor 6, a memory circuit 5 and a graphics peripheral 4 making it possible to generate a video signal from information contained in an area of the memory 5.

The device T for remote control of the graphics interface device D comprises a receiver circuit R, q sender circuits EMl, ..., EMk, ..., EMq, a microprocessor 3, a memory circuit 2 and user control means 1 such as, for example, a keypad or a joystick.

The sender circuit EMk (k=1, 2, ..., q) is a circuit that enables the signal IRMk to be sent. The signal IRMk is a generic notation for any one of the signals IRVi, IRAj, IRD, IRA or IRE. For reasons of convenience, the signal IRD mentioned in Figure 1 is here referenced IRM1 and the sender associated therewith is referenced EMl.

According to the invention, the format of the digital signal which modulates the signal IRT specifies, on the one hand, to which sender circuit EMk the item of information contained in the signal IRT is to be directed and, on the other hand, which modulation data are to be applied to the signal IRMk which the sender circuit EMk must send.

Modulation of the signal IRT is carried out with the aid of a modulation circuit contained in the sender/receiver circuit 7 and modulation of the signal IRMk with the aid of a modulation circuit contained in the sender circuit EMk. The receiver circuit R comprises means for analysing the signal IRT enabling it to extract the digital information contained in the signal IRT. This information can then be read by the microprocessor 3 and directed to the appropriate sender circuit EMk.

The modulation of the signal IRMk can be different from the modulation of the signal IRT even though the information contained in these signals may be identical.

The signal IRMk resent by the device T can thus be reformatted and transcoded by the device T so as to be adapted to the peripheral to be remotely controlled.

The digital signal for modulating the signal IRT and the digital signal for modulating the signal IRMk can be stored in the memory 2, under the control of a program executed by the microprocessor 3. The digital signal for modulating the signal IRMk can then be reread and resent, under the control of a program executed by the microprocessor 3 and triggered by the user acting on the user control device 1.

According to a particular embodiment of the invention, the modulation of the signal IRMk is identical to the modulation of the signal IRT. The remote control device T then behaves as a simple repeater of the signal IRT. The digital signal for modulating the signal IRT is stored in the device 2, under the control of a program executed by the microprocessor 3. The modulation signal stored can then be reread and resent by the sender EMk under the control of a program executed by the microprocessor 3 and triggered by the user acting on the user control device 1.

According to an improvement to the above-described embodiment of the invention, the format of the digital signal which modulates IRT specifies, on the one hand, an index whose value makes it possible to select and activate a microprogram from the list of microprograms which are stored in the memory 2 of the device T and which can be executed by the microprocessor 3 and, on the other hand, the data which have to be interpreted by these microprograms.

As is known to a person skilled in the art, a microprogram is a program whose instructions are written in binary code and can be exploited directly by the microprocessor.

In this format, each microprogram stored in the memory 2 is represented by an index contained in a table which holds the start-of-program addresses of all the microprograms. It is then possible to activate a particular microprogram by reading the element in the table, as referenced by the index received. Advantageously, the operating mode of the control device T can then be considerably extended in a simple manner.

By installing, with the aid of the signal IRT, a suitable protocol for communication between the device D and the device T in the software of the device T, the device D can take the memory 2 under its control and can download new microprograms and/or new data for parametrizing the software present in the memory 2 into this memory. The device D can then extend, reconfigure, or reprogram the facilities of the device T.

By installing a list of suitable microprograms, it is also possible to construct a control language interpreter in order to have the device T execute, under the control of the device D, programs involving the various elements 1, 2, 3, R, EMl, ..., EMk, ..., EMq.

The device D can thus take full control of the device T by means of the signal IRT, and then, by extension, take control of all of the peripherals by means of the signals IRMk.

The graphics interface device D is under the control, on the one hand, of graphics interface description information Igr stored in the memory 5, and, on the other hand, of a set of programs which are stored in the memory 5 and can be executed by the microprocessor 6.

The information Igr describes, for example, graphics objects, the control actions which these graphics objects represent and also the layout of these graphics objects on the screen page.

The programs stored in the memory 5 chiefly contain three facilities.

A first facility relates to the graphical generation of arrays of pixels. This facility comprises, for example, displaying a page background, positioning and displaying alphanumeric characters, positioning and displaying primitives of basic drawings (straight segments, triangles, rectangles, ellipses, various curves, etc.), and positioning and displaying arrays of pixels.

According to this facility, a cursor can, for example, be positioned and displayed on the screen page either by using the abovementioned drawing primitives, or directly by the graphics peripheral 4. The graphics peripheral 4 then reads the array of pixels generated and converts it into a video signal.

A second facility relates to the control of the graphics interface 4 by means of the signal IRD. Via the signal IRD, the device T despatches information relating to the positioning of the cursor on the screen and an item of information that makes it possible to trigger the action represented on the screen by the graphics object to which the cursor is pointing.

These items of information are received by the sender/receiver circuit 7 and are interpreted by the programs executed by the microprocessor 6. The microprocessor 6 controls, on the one hand, the positioning of the cursor on the graphics array in memory 5 and, on the other hand, activates the program which performs the command action linked with the graphics object over which the cursor is positioned, as specified by the graphics interface description information Igr.

A third facility relates to the control of the audio and/or video peripherals by the device D by means of the device T.

The programs which carry out the command actions are activated from the graphics interface 4. With at least one apparatus X (X = PV1, ..., PVi, ..., PVn, PA1, ..., PAj, ..., PAm, ..., D, A, E) there is associated at least one command program DrX stored in the memory 5.

Each command for apparatus X is indexed in a list. Each command program DrX takes as parameter the index corresponding to the command to be activated. Thus, a command action on the apparatus X is described in the software of the device D by: the identification number associated with the apparatus X, the index of the command to be activated and, possibly, of additional numerical parameters associated with this command. An additional parameter may, for example, be a number indicating the sound level desired by the user.

The command described above is used both as a call parameter for the programs for controlling the peripherals and as graphics interface description information Igr for associating a command with the graphics objects.

According to the invention, by way of the device 7, the command programs DrX transcribe the call parameters into the format of the digital signal modulating IRT.

While the device D is being powered up it must capture the information relating to the audio and/or video peripherals which makes it possible to set up and parametrize the command programs for the peripherals DrX in the memory 5. To initialize the communication protocols of the device T, the device D must configure the device T when the latter is operated for the first time. All the configuration information is stored in a permanent reprogrammable memory located in the memory 5.

When the device D is started up for the first time, the configuration information is input by means of specific graphics screens enabling the device D to input the characteristics of the various peripherals such as, for example, their make or model. A program then makes it possible to select from a set of predefined configurations those which correspond to the declared peripherals.

According to a more advanced embodiment of the start-up phase, the various remote controls of the various peripherals are used to ensure that the device T captures the various modulations which might be used. The device T or the device D can then capture the characteristics of these modulations whilst associating them with the graphics objects displayed with the aid of the device D. The information thus obtained is placed in memory in the circuit 5, under the control of a specific program for initializing the device D.

When the device T is functioning as the remote control for the graphics interface device D, the user control device 1 generates, under specific operations by the user, information that makes it possible to shift the cursor displayed on the screen. Another specific operation by the user on the user control device 1 generates the signal that triggers the action associated with the graphics object displayed on the screen and over which the cursor is positioned. This signal is appropriately coded by a microprogram stored in the memory 2. The signal IRD sent to the device D is then modulated by the appropriate sender EMk.

As has been described earlier, on the basis of the information which it retrieves, the device D executes the graphics display control programs and deduces the command program for the peripheral to be triggered. The latter program is carried out by means of the second function mode of the device T described above.

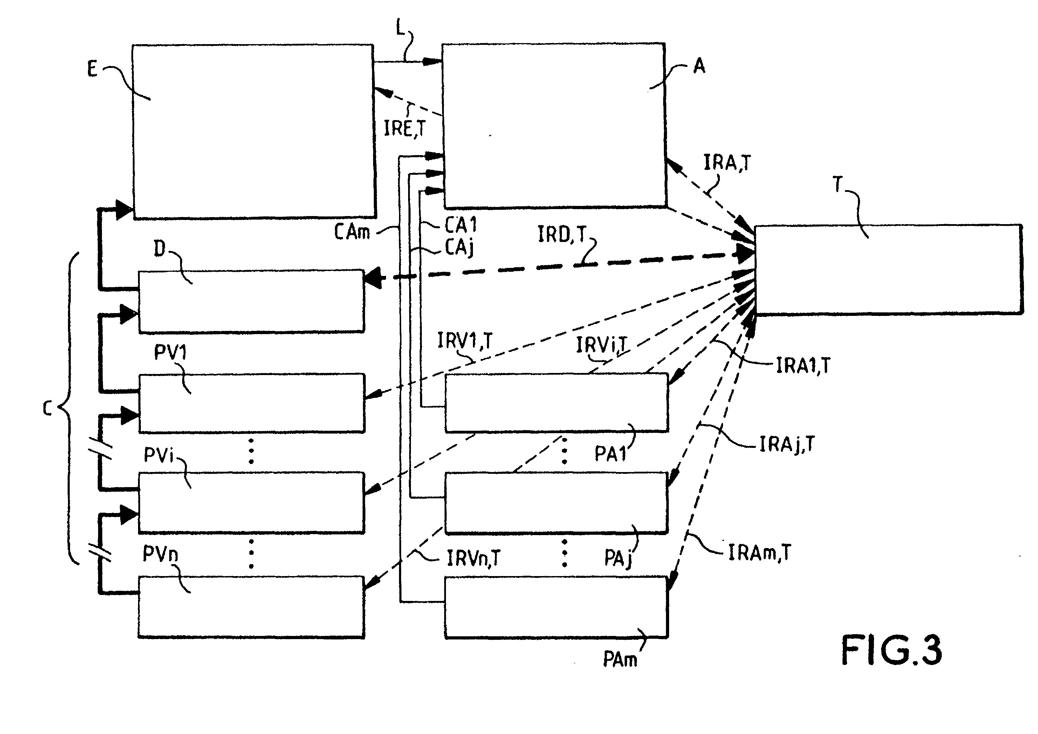

Figure 3 represents an improvement to the system represented in Figure 1.

The system represented in Figure 3 contains a set of n video peripherals PV1, ..., PVi, ..., PVn, n being an integer greater than or equal to 1, m audio peripherals PA1, ..., PAj, ..., PAm, m being an integer greater than or equal to 1, an audio amplifier A, a graphics interface device D, and a device T for remote control of the device D.

As with the system represented in Figure 1, the invention according to the embodiment represented in Figure 3 also relates to a system comprising only one or more video peripherals or, alternatively, a system comprising only one or more audio peripherals.

According to the improvement to the invention represented in Figure 3, at least one apparatus X (X=PV1, ..., PVi, ..., PVn, PA1, ..., PAj, ..., PAm, D, A, E) comprises not only a device making it possible to receive an infrared signal sent by the device T, but also a device making it possible to send a signal from the apparatus X to the device T. Thus, the device comprising the screen E can comprise means for sending a signal to the remote control device T.

The signal allowing the link between the apparatus X and the device T is denoted IRX,T.

Advantageously, the various peripherals can then send to the device D, by way of the device T, information relating to the video and/or audio programmes which they are storing (number of programmes, title of the programmes, coordinates of the programmes in the medium or media in which they are recorded or in the space of the available reception channels).

The graphics interface device D casts the information received from the peripherals into graphical form and enables it to be displayed on the screen E, by way of the video connections C. The peripheral can then be controlled by graphical viewing of the information displayed. By way of non-limiting example, the tracks of a compact disc can be selected from a menu displayed on a television screen. More generally, all the information capable of being viewed on the display devices on the front face of the peripherals can be transmitted to the device D, by way of the device T, so as to be viewed on the screen E. Similarly, all the commands can be issued by the user interacting with the graphics interface D.

In order to implement the above-defined routing of the information, each peripheral must carry out a link protocol. Each peripheral is then associated with a specific identification number previously defined by the constructor. When the peripherals are started up using a button on the remote control T, these specific identification numbers are transmitted to the device D by way of the device T so as to determine which configuration these peripherals are in.

According to an improvement to the above-defined start-up protocol, the device T can despatch a new identification number to one or more peripherals, which number the peripheral (peripherals) stores (store). The communication and routing protocol carried out by the device T then uses this identification number directly during each communication in order to determine which peripheral is sending the information.

The device T is programmed in such a way as to multiplex the signals which it can receive from the various peripherals X. The function of multiplexing the link between the peripherals X and the device T is performed on the initiative of the latter. The device T sends signals making it possible to select the periperhal X which can communicate with the device D, by way of the device T, and to specify to the peripheral X the maximum duration beyond which the communication will automatically be interrupted. In this way, the device T has the initiative in opening the temporary circuit for communication from the peripheral X to the device D. The peripheral X can then transmit information over the temporary communication circuit thus defined.

The device T is programmed in such a way as to carry out the routing of the information to be transmitted as a function of the origin and destination addresses. As has been described previously, a communication originating from the device D specifies the type of modulation and the format of the modulating signal.

In this way, the device T returns the appropriate signal to the only destination X capable of correctly interpreting the signal which it receives. According to the improvement to the invention, a communication originating from a peripheral X is steered directly, by the device T, to the device D by an information return mechanism similar to the mechanism for returning information from the device D to the peripheral X described previously.

The communication by way of the device T might not be fail-safe. This is because, owing to the possible presence of various obstacles, correct transmission is not always ensured between sender and receiver.

Provision is thus made, in a manner known per se, for a mechanism for the end-to-end control of communication so that the sender can be guaranteed that the data transmitted have been correctly received and the receiver can be guaranteed that the data received are those which were sent.

In another embodiment, communications can be set up from any peripheral X1 to any other peripheral X2. This assumes that each sender contained in a peripheral captures and stores, during the start-up phase, the digital modulation characteristics of the other peripherals. These modulation characteristics then make it possible to format the digital modulation signal sent by any peripheral so that the device T may correctly generate the signal which is to be received by the destination peripheral.

## Claims

1. Graphics interface device (D) allowing the presentation and display on a screen (E) of at least one item of information relating to at least one video and/or audio peripheral (X), the said graphics interface device (D) being remotely controllable by a remote control device (T) and **characterized in that** it comprises means (7) for sending, through the air, a first signal (IRT) to the remote control device (T), said first signal containing information for controlling the remote control device (T) to generate a second signal to be sent by the remote control device (T) to the peripheral (X), said second signal containing information for triggering a command action relating to the item of information represented on the screen (E).

2. Graphics interface device (D) according to Claim 1, **characterized in that** it comprises a memory circuit (5) containing at least one control program module (DrX) associated with at least one peripheral (X) .

3. Graphics interface device (D) according to either one of Claims 1 and 2, **characterized in that**, for a remote control device (T) containing a microprocessor (3) and a memory (2) containing at least one program that can be executed by the microprocessor (3), it comprises means for sending microprograms and/or data for parametrizing the executable program to the remote control device (T) for storage in the memory (2).

4. Remote control device (T) for a graphics interface device (D) allowing the presentation and display on a screen (E) of at least one item of information relating to at least one peripheral (X), **characterized in that** it comprises means (R, EM1, ..., EMk, ..., EMq) for receiving a first signal (IRT) output by the graphics interface device, said first signal containing information for controlling the remote control device (T) to generate a second signal, said means being adapted to send, to the peripheral (X), said second signal (IRMk) for =triggering a command action relating to the item of information represented on the screen (E).

5. Remote control device (T) according to Claim 4, **characterized in that** the second signal is generated by repeating the first signal.

6. Remote control device according to Claim 4, **characterized in that** the modulation of the second signal is different from the modulation of the first signals and/or **in that** the information contained in the second signal is the result of processing, by the remote control device, of the information contained in the first signal for adaptation to the peripheral to be remotely controlled.

7. Remote control device according to any one of Claims 4 to 6, **characterized in that** it comprises a microprocessor (3) and a memory circuit (2) containing at least one microprogram downloaded by way of the first signal (IRT) output by the graphics interface circuit (D).

8. Assembly consisting, on the one hand, of a graphics interface device (D) allowing the display on a screen (E) of at least one item of information relating to at least one video and/or audio peripheral (X) and, on the other hand, of a remote control device (T) for the graphics interface device (D), **characterized in that** the graphics interface device (D) is a device according to Claim 1, 2 or 3 and **in that** the remote control device (T) is a device according to any one of Claims 4 to 7.

9. System allowing the control, by graphical display on a screen (E), of at least one item of information relating to at least one video and/or audio peripheral, the said system comprising a device comprising the said screen (E), a graphics interface device (D), a remote control device (T) for the graphics interface device (D) and at least one video and/or audio peripheral (X), **characterized in that** the graphics interface device (D) is a device according to Claim 1, 2 or 3 and **in that** the remote control device (T) is a device according to any one of Claims 4 to 7.

10. System according to Claim 9, **characterized in that** at least one peripheral (X) comprises means for sending a third signal to the remote control device (T).

11. System according to Claim 9 or 10, **characterized in that** the device comprising the screen (E) comprises means for sending fourth signal to the remote control device (T).

12. System according to any one of Claims 9 to 11, **characterized in that** the device comprising the screen (E) is a television receiver.

## Patentansprüche

1. Grafik-Schnittstellen-Vorrichtung (D), die die Darstellung und die Anzeige von wenigstens einer Informations-Einzelheit, die sich auf wenigstens ein Video- und/oder Audio-Peripherie-Gerät (X) bezieht, auf einem Schirm (E) erlaubt, wobei die Grafik-Schnittstellen-Vorrichtung (D) durch eine Fernbedienungs-Vorrichtung (T) steuerbar ist, **dadurch gekennzeichnet, dass** sie Mittel (7) umfasst, um durch die Luft ein erstes Signal (IRT) zu der Fernbedienungs-Vorrichtung (T) zu senden, wobei das erste Signal Informationen zur Steuerung der Fernbedienungs-Vorrichtung (T) enthält, um ein zweites Signal zu erzeugen, das von der Fernbedienungs-Vorrichtung (T) zu dem Peripherie-Gerät (X) gesendet werden soll, wobei das zweite Signal Informationen enthält, um eine Befehlsaktion auszulösen, die sich auf die Informations-Einzelheit bezieht, die auf dem Bildschirm (E) dargestellt wird.

2. Grafik-Schnittstellen-Vorrichtung (D) nach Anspruch 1, **dadurch gekennzeichnet, dass** sie eine Speicher-Schaltung (5) umfasst, die wenigstens ein Steuer-Programm-Modul (DrX) enthält, das wenigstens einem Peripherie-Gerät (X) zugeordnet ist.

3. Grafik-Schnittstellen-Vorrichtung (D) nach einem der Ansprüche 1 und 2, **dadurch gekennzeichnet, dass** sie für die Fernbedienungs-Vorrichtung (T), die einen Mikroprozessor (3) und einen Speicher (2) enthält, der wenigstens ein Programm enthält, das von dem Mikroprozessor (3) ausgeführt werden kann, Mittel umfasst, um Mikroprogramme und/oder Daten zur Parametrisierung des ausführbaren Programms zu der Fernbedienungs-Vorrichtung (T) zur Speicherung in dem Speicher (2) umfasst.

4. Fernbedienungs-Vorrichtung (T) für eine Grafik-Schnittstellen-Vorrichtung (D), die die Darstellung und die Anzeige von wenigstens einer Informations-Einzelheit, die sich auf wenigstens ein Peripherie-Gerät (X) bezieht, auf dem Schirm erlaubt, **dadurch gekennzeichnet, dass** sie Mittel (R, EM1, ... , EMk, ... , EMq) zum Empfang eines ersten Signal-(IRT)-Ausgangs durch die Grafik-Schnittstellen-Vorrichtung umfasst, dass das erste Signal Informationen zur Steuerung der Fernbedienungs-Vorrichtung (T) umfasst, um ein zweites Signal zu erzeugen, dass die Mittel angepasst sind, um an das Peripherie-Gerät (X) das zweite Signal (IRMk) zu senden, um eine Befehls-Aktion auszulösen, die sich auf die Informations-Einzelheit bezieht, die auf dem Bildschirm (E) dargestellt wird.

5. Fernbedienungs-Vorrichtung (T) nach Anspruch 4, **dadurch gekennzeichnet, dass** das zweite Signal durch Wiederholung des ersten Signals erzeugt wird.

6. Fernbedienungs-Vorrichtung nach Anspruch 4, **dadurch gekennzeichnet, dass** die Modulation des zweiten Signals sich von der Modulation des ersten Signals unterscheidet und/oder dass die in dem zweiten Signal enthaltenen Informationen das Ergebnis einer Verarbeitung der in dem ersten Signal enthaltenen Informationen durch die Fernbedienungs-Vorrichtung zur Anpassung an das fernzubedienende Peripherie-Gerät ist.

7. Fernbedienungs-Vorrichtung nach einem der Ansprüche 4 bis 6, **dadurch gekennzeichnet, dass** sie einen Mikroprozessor (3) und eine Speicher-Schaltung (2) umfasst, die wenigstens ein Mikroprogramm enthält, das durch das erste Signal (IRT) heruntergeladen wird, das von der Grafik-Schnittstellen-Schaltung (D) ausgegeben wird.

8. Anordnung, die einerseits aus einer Grafik-Schnittstellen-Vorrichtung (D) besteht, die die Anzeige wenigstens einer Informations-Einzelheit, die sich auf wenigstens ein Video- und/oder Audio-Peripherie-Gerät (X) bezieht, auf einem Bildschirm (E) erlaubt, und die andererseits aus einer Fernbedienungs-Vorrichtung (T) für die Grafik-Schnittstellen-Vorrichtung (D) besteht, **dadurch gekennzeichnet, dass** die Grafik-Schnittstellen-Vorrichtung (D) eine Vorrichtung gemäß Anspruch 1, 2 oder 3 ist, und dass die Fernbedienungs-Vorrichtung (T) eine Vorrichtung gemäß einem der Ansprüche 4 bis 7 ist.

9. System, das durch grafische Anzeige auf einem Bildschirm (E) die Steuerung wenigstens einer Informations-Einzelheit erlaubt, die sich auf wenigstens ein Videound/oder Audio-Peripherie-Gerät bezieht, wobei das System eine Vorrichtung umfasst, die den Bildschirm (E), eine Grafik-Schnittstellen-Vorrichtung (D), eine Fernbedienungs-Vorrichtung (T) für die Grafik-Schnittstellen-Vorrichtung (D) und wenigstens ein Video- und/oder Audio-Peripherie-Gerät (X) umfasst, **dadurch gekennzeichnet, dass** die Grafik-Schnittstellen-Vorrichtung (D) eine Vorrichtung gemäß Anspruch 1, 2 oder 3 ist, und dass die Fernbedienungs-Vorrichtung (T) eine Vorrichtung gemäß einem der Ansprüche 4 bis 7 ist.

10. System nach Anspruch 9, **dadurch gekennzeichnet, dass** wenigstens ein Peripherie-Gerät (X) Mittel zum Senden eines dritten Signals zu der Fernbedienungs-Vorrichtung (T) enthält.

11. System nach Anspruch 9 oder 10, **dadurch gekennzeichnet, dass** die den Bildschirm (E) enthaltende Vorrichtung Mittel zum Senden eines vierten Signals zu der Fernbedienungs-Vorrichtung (T) enthält.

12. System nach einem der Ansprüche 9 bis 11, **dadurch gekennzeichnet, dass** die den Bildschirm (E) enthaltende Vorrichtung ein Fernsehempfänger ist.

## Revendications

1. Dispositif d'interface graphique (D) permettant la présentation et l'affichage sur un écran (E) d'au moins un élément d'information concernant au moins un périphérique vidéo et/ou audio (X), ledit dispositif d'interface graphique (D) étant contrôlable à distance par un dispositif de commande à distance (T) et **caractérisé en ce qu'**il comporte un dispositif (7) permettant d'envoyer, sans fil, un premier signal (IRT) au dispositif de commande à distance (T), ledit premier signal contenant des informations pour le contrôle du dispositif de commande à distance (T) en vue de générer un deuxième signal qui doit être envoyé par le dispositif de commande à distance (T) au périphérique (X), ledit deuxième signal contenant des informations pour le déclenchement d'une action de commande relative à l'élément d'information représenté à l'écran (E).

2. Dispositif d'interface graphique (D) selon la revendication 1, **caractérisé en ce qu'**il comporte un circuit à mémoire (5) contenant au moins un module de contrôle de programme (DrX) associé à au moins un périphérique (X).

3. Dispositif d'interface graphique (D) selon la revendication 1 ou 2, **caractérisé en ce que**, pour un dispositif de commande à distance (T) contenant un microprocesseur (3) et une mémoire (2) contenant au moins un programme qui peut être exécuté par le microprocesseur (3), il comprend un dispositif d'envoi de microprogrammes et/ou de données pour le paramétrage du programme exécutable au dispositif de commande à distance (T) pour stockage dans la mémoire (2).

4. Dispositif de commande à distance (T) d'un dispositif d'interface graphique (D) permettant la présentation et l'affichage sur un écran (E) d'au moins un élément d'information concernant au moins un périphérique (X), **caractérisé en ce qu'**il comprend un dispositif (R, EM1, ..., EMk, ..., EMg) de réception d'un premier signal (IRT) émis par le dispositif d'interface graphique, ledit premier signal contenant des informations pour le contrôle du dispositif de commande à distance (T) pour générer un deuxième signal, ledit dispositif étant adapté pour envoyer au périphérique (X) ledit deuxième signal (IRMk) contenant des informations pour le déclenchement d'une action de commande relative à l'élément d'information présenté à l'écran (E).

5. Dispositif de commande à distance (T) selon la revendication 4, **caractérisé en ce que** le deuxième signal est généré par répétition du premier signal.

6. Dispositif de commande à distance (T) selon la revendication 4, **caractérisé en ce que** la modulation du deuxième signal diffère de la modulation du premier signal et/ou **en ce que** les informations contenues dans le deuxième signal sont issues du traitement par le dispositif de commande à distance des informations contenues dans le premier signal pour adaptation au périphérique à contrôler à distance.

7. Dispositif de commande à distance (T) selon l'une des revendications 4 à 6, **caractérisé en ce qu'**il comprend un microprocesseur (3) et un circuit à mémoire (2) contenant au moins un microprogramme téléchargé au moyen du premier signal (IRT) émis par le circuit d'interface graphique (D).

8. Assemblage constitué d'une part d'un dispositif d'interface graphique (D) permettant l'affichage sur un écran (E) d'au moins un élément d'information concernant au moins un périphérique vidéo et/ou audio (X) et d'autre part d'un dispositif de commande à distance (T) du dispositif d'interface graphique (D), **caractérisé en ce que** le dispositif d'interface graphique (D) est un dispositif selon la revendication 1, 2 ou 3 et **en ce que** le dispositif de commande à distance (T) est un dispositif selon l'une des revendications 4 à 7.

9. Système permettant de contrôler par affichage graphique sur un écran (E) au moins un élément d'information concernant au moins un périphérique vidéo et/ou audio, ledit système comprenant un dispositif qui comporte ledit écran (E) un dispositif d'interface graphique (D), un dispositif de commande à distance (T) pour le dispositif d'interface graphique (D) et au moins un périphérique vidéo et/ou audio (X), **caractérisé en ce que** le dispositif d'interface graphique (D) est un dispositif selon la revendication 1, 2 ou 3 et **en ce que** le dispositif de commande à distance (T) est un dispositif selon l'une des revendications 4 à 7.

10. Système selon la revendication 9, **caractérisé en ce qu'**au moins un périphérique (X) comporte un dispositif d'envoi d'un troisième signal au dispositif de commande à distance (T).

11. Système selon la revendication 9 ou 10, **caractérisé en ce que** le dispositif comportant l'écran (E) comporte un dispositif d'envoi d'un quatrième signal au dispositif de commande à distance (T).

12. Système selon l'une des revendications 9 à 11, **caractérisé en ce que** le dispositif comportant l'écran (E) est un récepteur de télévision.
